# EUROPEAN PATENT APPLICATION

(11) **EP 4 646 061 A2**
(43) Date of publication of application: **05.11.2025**
(21) Application number: 25163840.9
(22) Date of filing: 14.03.2025
(51) Int. Cl.: H10F 10/19, H10F 19/90, H10F 77/30, H10K 85/50

(54) **DEVICE AND PROCESS FOR FORMING HIGH DURABILITY MULTIJUNCTION SOLAR CELLS**

(30) Priority: 11.04.2024 US 202418632586
(71) Applicant: The Boeing Company, Arlington, VA 22202 (US)
(72) Inventor: Fetzer, Christopher M., Arlington, 22202 (US)
(74) Representative: Witte, Weller & Partner Patentanwälte mbB

(57) **Abstract**

A multijunction photovoltaic device is disclosed, including a first subcell that may include a base semiconductor layer and a second semiconductor layer, where the base semiconductor layer may include a group III-V semiconductor material, a second subcell on the first subcell which includes an absorber layer comprising an organometallic halide ionic solid perovskite semiconductor material. The device also includes a passivation layer (212) on at least a portion of a top surface of the first subcell. The multijunction photovoltaic device also includes an n-side metal pad in contact with the passivation layer (212) on an n-side of the second subcell. Implementations may include an interconnection tab in contact with the n-side metal pad or in contact with the second subcell. The passivation layer (212) may include an oxide layer. The passivation layer (212) may include a material selected from a group may include of SiO₂, Al₂O₃, TiO₂, Ta₂O₃, HfO₂, ZnS, and combinations thereof.

## Description

### TECHNICAL FIELD

The present teachings relate generally to optoelectronic semiconductor structures, such as solar cells, photodetectors and the like, which are broadly referred to herein as solar cells and, more particularly, to heterojunction solar cells and methods of making the same.

### BACKGROUND

A solar cell is a photovoltaic (PV) device that is capable of converting incident light energy, and specifically solar energy (sunlight), to electrical energy by the photovoltaic effect. The interest in solar cells has been increasing due to concerns regarding pollution, energy security, and limited available resources. This interest has been for both terrestrial and non-terrestrial (space) applications.

In terrestrial applications, higher solar cell efficiency for conversion of sunlight to electricity results in a smaller collecting area required for a given electrical power output, and therefore lower cost per watt, and greater cost effectiveness for a terrestrial photovoltaic system. The cost per watt of electrical power generation capacity of photovoltaic systems inhibits their widespread use in terrestrial applications. The conversion efficiency of sunlight to electricity may be critically important for terrestrial PV systems, since increased efficiency usually results in a reduction of related electricity generation system components (such as cell area, module or collector area, support structures, and land area) for a required power output of the system. For example, in concentrator solar cell systems which concentrate sunlight from around 2 to around 2000 times onto the solar cell, an increase in efficiency typically results in a proportionate reduction of an area comprising expensive concentrating optics.

In space applications, the use of nuclear or battery power greatly increases a spacecraft's payload for a given amount of required power to operate the satellite. Increasing the payload of a spacecraft in this manner increases the cost of a launch more than linearly. With the ready availability of solar energy in space for a spacecraft such as a satellite, the conversion of solar energy into electrical energy has proven to be a good alternative to an increased payload and the development of higher efficiency solar cells enables further increased payload capabilities.

To increase their electrical power output, solar cells may have one or more photovoltaic junctions (multijunction), which are one or more component photovoltaic cells and are also called subcells. The subcell/junction may include corresponding photovoltaic semiconductor layers having different energy bandgaps and may be stacked so that each subcell can absorb a different part of the wide energy distribution in the sunlight. Incident light energy of different ranges of wavelengths may be converted at a corresponding one or more of the junctions.

These component photovoltaic cells, or subcells, may be connected in series to form a multijunction solar cell, but may also be connected in other electrical configurations, such as in parallel, or in a combination of series and parallel connections. The stacked multijunction arrangement is advantageous, since each photon absorbed in a subcell corresponds to one unit of charge that is collected at the subcell operating voltage, which is approximately linearly dependent upon the bandgap of the semiconductor material of the subcell. Since the output power is the product of voltage and current, an ideally efficient solar cell would have a large number of subcells, each absorbing only photons of energy negligibly greater than its bandgap.

In multijunction solar cells it is often desirable to modify the bandgaps of the semiconductor layers that form the subcells within the multijunction cell, and thereby modify the subcell voltages and wavelength ranges over which the subcells respond to incident light, for instance, to space and terrestrial solar spectra. The specific bandgaps and thicknesses of layers that form the subcells within a multijunction cell determine the subcell voltages, the current densities of each subcell, whether the subcell current densities can be matched to one another as is desired in a series-interconnected multijunction cell, and how the broad solar spectrum is divided into narrower wavelength ranges by the combination of subcell bandgaps to achieve higher sunlight-to-electricity conversion. A crucial technological challenge in the design of multijunction solar cells is how to achieve the optimum or near-optimum combination of subcell layer bandgaps, and how to achieve the desired wavelength ranges of subcell response--the wavelength ranges in which the subcells have photogenerated current that can be collected usefully--in order to maximize the multijunction solar cell efficiency. Often the semiconductors that are readily useable--e.g., semiconductors that are lattice-matched to relatively common, inexpensive substrates; that can be grown with favorable minority-carrier properties such as lifetime and mobility; or that do not cause unwanted doping or impurities in other parts of the cell--do not have the bandgaps that result in the most favorable combination of multijunction subcell bandgaps for conversion of the solar spectrum.

The most efficient and, therefore, dominant multijunction (MJ) PV cell technology is the GaInP/Ga(In)As/Ge cell structure. Here the use of parentheses in the Ga(In)As middle subcell material indicates that the incorporation of indium in the middle cell is optional, so that the composition of the middle cell may be either GaAs or GaInAs. These monolithic cells may be grown lattice-matched to GaAs or Ge, and may have only the top two junctions active with an inactive Ge substrate (2-junction or 2J cells), or all three junctions may be active (3-junction or 3J cells). While variations on this material system, such as AlGaInP or lattice-mismatched GaInP top cells, might provide a more ideal match of bandgaps to the solar spectrum, practical considerations have indicated that lattice-matched GaInP is preferred for large-scale production.

Traditionally, the current generated by each subcell was controlled by reducing the subcell voltage. Specifically, the alloy composition of the base semiconductor layer of the subcell was engineered to yield the desired amount of current. For example, lower bandgap alloys have been used in the base semiconductor layer to achieve a higher current output at the expense of a lower output voltage for the subcell. In monolithic, series-interconnected, 2-junction and 3-junction GaInP/Ga(In)As/Ge solar cells, it is desirable for the GaInP top subcell to have nearly the same photogenerated current density as the Ga(In)As subcell. If the currents are different, the subcell with the lowest photogenerated current will limit the current through all of the series-interconnected subcells in MJ cell, and excess photogenerated current in other subcells is wasted. Limiting the current in this manner results in a severe penalty on the MJ cell efficiency. However, one potential approach to improving the existing triple-junction GaInP/Ga(In)As/Ge multijunction solar cell device is to add one or more additional junctions.

The power conversion efficiency of a subcell is a function of both the output voltage and the output current. Therefore, an approach for current matching the subcells of a solar cell can be based on an overall multijunction tandem in series which can create a maximum current and therefore higher efficiency.

Recent progress in dye-sensitized solar cells (DSSC) has produced a novel material category for solar power conversion. The combined organic-metal halide formed in perovskite crystal and deposited at low temperature as a polycrystalline layer has achieved a pathway to low cost, high efficiency solar power conversion. Recent reporting indicates a lab measured 20.1% efficiency under terrestrial standard conditions (AM1.5G, 25°C), rivaling efficiencies of standard silicon wafer based technologies. With the grand increase in efficiency, the research improvements have increased immensely and the field is evolving rapidly. And with each reported new record, some consistent issues are appearing with the materials. Many limitations, new materials and device engineering challenges are being elucidated. For example, overcoming issues related to radiation tolerance, e.g., resistance of new materials to UV damage, without sacrificing device performance or increasing cost is of particular interest. Improved multijunction solar (photovoltaic) cells and methods for making the same would be welcome additions to the art.

Current state of the art development of tandem solar cells include new materials such as perovskite thin film layers. Perovskites and similar materials are low cost because of their low deposition temperatures to form high quality layers. These can be as low as below 100°C. The disadvantage of low formation temperature is that typical robust assembly methods of connecting cells together such as solder or welding will evaporate or degrade the perovskite layers. Thus, there is a need for incorporating perovskite layers within solar cells while accommodating the lower temperature stability of perovskite-based materials.

### SUMMARY

The following presents a simplified summary in order to provide a basic understanding of some aspects of one or more embodiments of the present teachings. This summary is not an extensive overview, nor is it intended to identify key or critical elements of the present teachings, nor to delineate the scope of the disclosure. Rather, its primary purpose is merely to present one or more concepts in simplified form as a prelude to the detailed description presented later.

A multijunction photovoltaic device is disclosed. The multijunction photovoltaic device includes a first subcell that may include a base semiconductor layer and a second semiconductor layer, where the base semiconductor layer may include a group III-V semiconductor material, a second subcell on the first subcell which may include an absorber layer, where the absorber layer may include an organometallic halide ionic solid perovskite semiconductor material. The device also includes a passivation layer on at least a portion of a top surface of the first subcell. The device also includes an n-side metal pad in contact with the passivation layer on an n-side of the second subcell. Implementations of the multijunction photovoltaic device may include an interconnection tab in contact with the n-side metal pad. The interconnection tab is in contact with the second subcell. The interconnection tab may include a metal. The n-side metal pad and the interconnection tab may include two different metals. The n-side metal pad and the interconnection tab are on a single side of the multijunction photovoltaic device. The passivation layer may include an oxide layer. The passivation layer may include a material selected from a group may include of SiO₂, Al₂O₃, TiO₂, Ta₂O₅, HfO₂, ZnS, and combinations thereof. The passivation layer is adjacent to the second subcell. The second subcell does not completely cover the first subcell.

Another multijunction photovoltaic device is disclosed. The multijunction photovoltaic device includes a first subcell may include a base semiconductor layer and a second semiconductor layer, where the base semiconductor layer may include a group III-V semiconductor material, a second subcell on a surface of the first subcell may include an absorber layer, where the absorber layer does not include a perovskite semiconductor material. The device also includes a passivation layer on at least a portion of a top surface of the first subcell. The device also includes an n-side metal pad in contact with the passivation layer on an n-side of the second subcell. The device also includes a grid finger in contact with the n-side metal pad and the second subcell. Implementations of the multijunction photovoltaic device can include where the passivation layer is adjacent to the second subcell. In implementations, the second subcell does not completely cover the first subcell.

A method of forming a multijunction solar cell is disclosed. The method of forming a multijunction solar cell can include forming a substrate subcell which may include an n-side, a backside, a base semiconductor layer and a second semiconductor layer, where the base semiconductor layer may include a group III-V semiconductor material. The method also includes forming a passivation layer to protect an n-side of the substrate subcell. The method also includes forming a high temperature metal deposition on a backside of the substrate subcell. The method also includes forming an interconnection tab in contact with the passivation layer. The method also includes forming a second subcell may include an absorber layer, where the absorber layer does not include a perovskite semiconductor material. The method also includes forming a front-side metallization connecting to pads using a low temperature deposition. Implementations of the method of forming a multijunction solar cell where the passivation layer may include an oxide layer. The interconnection tab can be in contact with the second subcell. The substrate subcell may include base semiconductor layer may include Si, GaAs, or Ge. The method of forming a multijunction solar cell may include assembly of one or more multijunction solar cells into an array of cells. The method of forming a multijunction solar cell may include forming the interconnection tab by soldering at an elevated temperature. The method of forming a multijunction solar cell may include forming the interconnection tab by welding at an elevated temperature.

The features, functions, and advantages that have been discussed can be achieved independently in various implementations or can be combined in yet other implementations further details of which can be seen with reference to the following description.

### BRIEF DESCRIPTION OF THE DRAWINGS

The accompanying drawings, which are incorporated in and constitute a part of this specification, illustrate embodiments of the present teachings and together with the description, serve to explain the principles of the disclosure. In the figures:
FIG. 1 is a cross-sectional views of some aspects of prior art solar cell structures, in accordance with the present disclosure.
FIG. 2 is a cross-sectional view of some aspects of a multijunction solar cell structure, in accordance with the present disclosure.
FIG. 3 is a flowchart illustrating a prior art method of fabricating a solar cell, in accordance with the present disclosure.
FIG. 4 is a flowchart illustrating a method of fabricating a solar cell, in accordance with the present disclosure.
FIG. 5 is a diagram of the International Space Station (ISS) which may employ the disclosed multijunction photovoltaic device(s).

It should be noted that some details of the figures have been simplified and are drawn to facilitate understanding of the present teachings rather than to maintain strict structural accuracy, detail, and scale.

### DETAILED DESCRIPTION

Reference will now be made in detail to exemplary embodiments of the present teachings, examples of which are illustrated in the accompanying drawings. Wherever possible, the same reference numbers will be used throughout the drawings to refer to the same, similar, or like parts.

Notwithstanding that the numerical ranges and parameters setting forth the broad scope of the examples are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein. For example, a range of "less than 10" can include any and all sub-ranges between (and including) the minimum value of zero and the maximum value of 10, that is, any and all sub-ranges having a minimum value of equal to or greater than zero and a maximum value of equal to or less than 10, e.g., 1 to 5. In certain cases, the numerical values as stated for the parameter can take on negative values. In this case, the example value of range stated as "less that 10" can assume negative values, e.g. -1, -2, -3, - 10, -20, -30, etc.

Further, one or more of the acts depicted herein may be carried out in one or more separate acts and/or phases. Furthermore, to the extent that the terms "including," "includes," "having," "has," "with," or variants thereof are used in either the detailed description and the claims, such terms are intended to be inclusive in a manner similar to the term "comprising." Additionally, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "at least one of" is used to mean one or more of the listed items may be selected. As used herein, the phrase "one or more of', for example, A, B, and C means any of the following: either A, B, or C alone; or combinations of two, such as A and B, B and C, and A and C; or combinations of three A, B and C.

As used herein, the terms "doped" or "doping" (and variants thereof), as it pertains to semiconductor material or layers comprising semiconductor material, refers to the introduction of or presence of impurity "dopant" elements that are deliberately added to, for example, extrinsic semiconductors, so as to induce a change in the inherent electrical conductivity of the semiconductor material.

As understood to those of ordinary skill in the semiconductor art, the "type" of dopant describes the relative amount of valence electrons of impurity atoms as compared to the atoms of the semiconductor they exist in or are introduced to. That is, p-type dopants have fewer valence and n-type dopants having more valence electrons than the semiconductor. In common usage, the notation "p-doped" indicates that a semiconductor has been doped with p-type dopants so as to increase the number of positive charge carriers relative to the number of negative charge carriers in the semiconductor, and "n-doped" indicates that a semiconductor has been doped with n-type dopants so as to increase the number of negative charge carriers relative to positive charge carriers in the semiconductor.

As understood to those of ordinary skill in the semiconductor art, the "level" of dopant describes the concentration of the dopant impurity in the semiconductor. For example, as used herein, "lightly doped" indicates that the level of doping is about 1014 to about 1015 dopant atoms/cm3, "medium doped" indicates that the level of doping is about 1016 to about 1017 dopant atoms/cm3, and "heavily doped" indicates that the level of doping is about 1018 to about 1019 dopant atoms/cm3. Accordingly, as used herein, the notation "p+" or "n+" indicates that a corresponding semiconductor is medium doped p-type or n-type, respectively, and " doped and "p++" or "n++" indicates that a corresponding semiconductor is heavily doped p-type or n-type, respectively.

The following examples are described for illustrative purposes only with reference to the Figures. Those of skill in the art will appreciate that the following description is exemplary in nature, and that various modifications to the parameters set forth herein could be made without departing from the scope of the present examples. It is intended that the specification and examples be considered as exemplary only. The various examples are not necessarily mutually exclusive, as some examples can be combined with one or more other examples to form new examples. It will be understood that the structures depicted in the figures may include additional features not depicted for simplicity, while depicted structures may be removed or modified.

Perovskite material is relatively new, and known for use in solar cells or photovoltaic device fabrication and use. Perovskite materials are low-cost, do not require expensive processing equipment, do not require high temperature processing, and the like. Devices incorporating perovskite can offer higher efficiency solar cells at much lower cost. Typically, a tandem solar cell or multijunction solar cell is deisrable. Tandem solar cells as described can include a top junction and a bottom junction, mostly are on silicon substrates. Other implementations include perovskite with III-V group materials. Advantageously, perovskite can be deposited near 100°C, as compared to 600 - 700°C for III-V materials.

A drawback of perovskite includes that as it can be processed at low temperatures, it can also be compromised at low temperatures. Most of the temperature stress can be found within the assembly process, including the steps involving connecting multiple cells together. In fact, such connections can be a weak point in the fabrication process. For example, silicon-based panels are soldered and wired together, and in a case of space solar cells, they can be brazed or welded at higher temperatures using a short pulse of very high current. These techniques, when employed to cells or devices including perovskite can evaporate perovskite, as temperatures of 300-400°C in seconds. The disadvantage of low formation temperature is that typical robust assembly methods of connecting cells together such as solder or welding will evaporate or degrade the perovskite layers. Thus, typical state of the art perovskite tandem solar cells lack a robust method to interconnect the cells that will survive the requirements for durability to space environments such as temperature cycling. In general, other potential devices may be contemplated using a low robust or low process temp upper subcell or set of subcells.

Therefore, the method and means of interconnecting is a major issue in cells or devices including perovskite. For example, silver tabs or silver inks are not robust, and for space utilization, these cells and devices need to survive thermal environments and be extremely robust. They need to survive a minimum of 150°C at a higher temperature range, and at a minimum temperature range of -100 to -200°C in colder environments. Thus, the present disclosure provides a method that can separate where the welded interconnect joint is made from the use and assembly portion involving perovskite. In implementations, the deposition of an insulating contact onto the silicon, such as an oxide, silicon dioxide, aluminum oxide, or aluminum nitride insulator can serve to keep the top contact of device from touching the bottom of a device to prevent it from shorting. Further, this provides a weldable or solderable connection. Additional examples including the use of two different metals for an n-side metal and metal grid finger (interconnection tab) need not use the same metal. A metal can be deposited, sintered at 200-400°C, followed by a deposition of perovskite. High temperature processing is completed first, followed by connection formation with the low temperature portion. N-side metal contacts can include low resistance metals, such as silver, copper, alloys, complex structure such as a multilayered structure or alloy. It should be noted that aluminum is not typically suitable for this contact material. The interconnect tab, also referred to as a grid finger, could be aluminum or comprise a metal other than the n-side metal contact, and should be low resistance as well. These two metal pads do not need to be the same material or be solderable. They can include different materials or different deposition techniques, such as screen printing, evaporation, or deposition, for example. Typical metals can include, but are not limited to, noble metals such as Cu, Ag, and Au for conduction. However, metal stacks can be composed of numerous alloy layers that may include metals acting as dopants such as Fe, Ge or Zn, or metals acting as diffusion or adhesion layers such as Ti, Ni, W, Pt, Pd as commonly known by those current in the state of the art.

The method and devices disclosed herein provide devices that sacrifice some active area, since the portion of the cell including the insulation tab or portion, and as such, the perovskite layer being only a partial layer, the insulating portion does not transmit solar energy. This small portion of efficiency is sacrificed to attain improved processing and interconnectivity between cells. In examples of the present disclosure, there is no limit to number of cells, where for example, arrays of 2 cells to 1000 cells could be used. In still other implementations, for example, the interconnect can also be used as a bus wire to extract power, send to battery, and the like. While perovskite is noted as a low temperature component in cells and devices of the present disclosure, other low temp materials can including copper indium gallium diselenide, cadmium zinc telluride, and the like can also be used. Additional semiconductor systems could include chalcogenide thin film systems like CdS, CdSe, ZnTe, ZnSe, as well as polymeric solar cells materials.

The present disclosure provides a device and process for forming high durability multijunction solar cells. The current state of the art development of tandem solar cells includes new materials such as perovskite thin film layers. For tandem solar cells, perovksites (Pvk) can be layered onto silicon substrates for a perovskite/silicon 2J (two-junction) device. Such devices offer a low-cost pathway to higher efficiency photovoltaics over traditional cells. Perovskites and similar materials are low cost because of their low deposition temperatures to form high quality layers. These can be as low as below 100°C.

The present disclosure takes advantage of a robust subcell below the perovskite layer. Typically, this subcell is made of single crystalline silicon to form the bottom subcell of a Pvk/Si 2J device. Typical assembly processes involve forming contacts using metals deposited on top and bottom of the cell. In the present examples, those contact pads are formed onto the silicon subcell. Critical to forming all the contacts onto the bottom subcell is the addition of an insulating layer underneath the top-side contact. This layer allows the connection of the top-most layer of the tandem upper subcell without forming a short pathway across the top junction. A final step can include the addition of one or more contacting fingers onto the perovskite top subcell which then connects the pad and the top layer of the pn-junction diode. This can reduce the area of the top junction with respect to the bottom junction.

Since series interconnection is also a challenge, the described method could include both contacts on a single side of the device. In examples, top-top (sunward) contacts can be used, or alternatively, both contacts can be on the bottom (opposite sunward). Additionally, a preferred series interconnection could include the use of a flex circuit embedding traces to avoid welding or solder directly to the adjacent cell during series interconnection. Similar techniques could be employed in the fabrication of additional 2J and higher multijunction devices where the upper subcell is susceptible to high temperature damage from metal deposition or welding or soldering assembly steps. Examples can include a bonded layer (spalled or lift-off) III-V cell (AlGaAs or AlGaInP/AlGaAs/GaAs) onto a Silicon subcell as a 2J, 3J or 4J device or II-VI polycrystalline devices onto a passivated Si or Ge subcell. These include where on silicon, a 1.7 eV/1.1 eV 2J (1.4 to 1.9 eV (preferable ~1.7 eV) CuGaInSe or CdZnTe thin film device), would require conductive layer between upper and lower subcells (Tunnel device on Si side prior to deposition of the II-VI alloy subcell. Alternatively, on germanium, a GaAs/Ge 2J with a low cost 1.9 eV II-VI alloy device (1.9 - 2.0 eV CdZnTe poly crystalline device)

Generally described herein are solar cells, including multijunction solar cells, that utilize at least one III-V semiconductor layer and, in examples, at least one perovskite material layer, these layers disposed within one subcell and/or disposed in different subcells of the same multijunction photovoltaic device for improved current densities. In one implementation, the III-V semiconductor layer(s) are configured to act as an absorber/attenuator of ultraviolet (UV) light in order to minimize or prevent any damage to the perovskite material layer. More specifically, described herein are high-efficiency multijunction photovoltaic cells that may be used with, for example, a satellite and manned or unmanned spacecraft and space probes. In one approach, the weakest junction under radiation effects (e.g., a GaAs subcell) in a GaInP/GaAs/Ge 3-junction photovoltaic device may be replaced with a perovskite subcell (e.g., GaInP/Perovskite/Ge) to improve overall radiation tolerance. In certain examples, the perovskite material layer is not present, and in place of a perovskite material, the multijunctional solar cells can include other materials processable at lower temperatures, for example, lower than at 100°C such as, but not limited to material including copper indium gallium diselenide (CuInGaSe₂), cadmium zinc telluride (CdZnTe), CdS, CuS, SuSe, CdSe, HgCdTe, and the like.

In radiation performance of conventional solar cells, such as III-V and IV solar cells, two key physical properties contribute to the solar cells performance retention: first, the amount of damage the material receives in terms of defects created in the material per ionizing particle; and second, the location of the defect in the energy gap and hence the efficacy of the defect to act as non-radiative recombination site. Accordingly, solar cells described herein can utilize organo-lead halide materials as these materials have shown superior performance over conventional solar cell materials.

For example, the amount of damage a material receives from a radiation particle-e.g., displacement of atoms from the lattice-is proportional to the mass of the atoms. In GaAs, both Ga and As are typically displaced from the lattice with high-energy electrons and proton radiation from elastic collisions known as displacement damage. While not limited to any particular theory, it is believed that because the central atoms and ions that make up perovskite materials have greater mass than the constituent atoms of, for example, Ga and As in conventional III-V photovoltaic device subcells, the displacement damage caused by such particle radiation will be reduced in comparison between the perovskite and GaAs materials. Thus, it is believed that the perovskite material should exhibit fewer centers than an equivalent GaAs solar cell given the same radiation dose.

Additionally, in photovoltaic devices, the bandgap energy of the recombination region controls photon absorption. However, energy states introduced through defects in the crystal lattice of perovskite materials are known to be outside this bandgap. Specifically, defects in organo lead iodide perovskites at grain boundaries do not produce effective non-radiative recombination centers. Thus, while not limited to any particular theory, it is believed that for perovskite subcells in photovoltaic devices such as in a space radiation environment application-i.e., solar cells used in space-even when defects are created by particle radiation, they will be ineffective as recombination sites. Accordingly, it is further believed that perovskite solar cells will be only lightly affected by space radiation.

### Multijunction Photovoltaic Devices

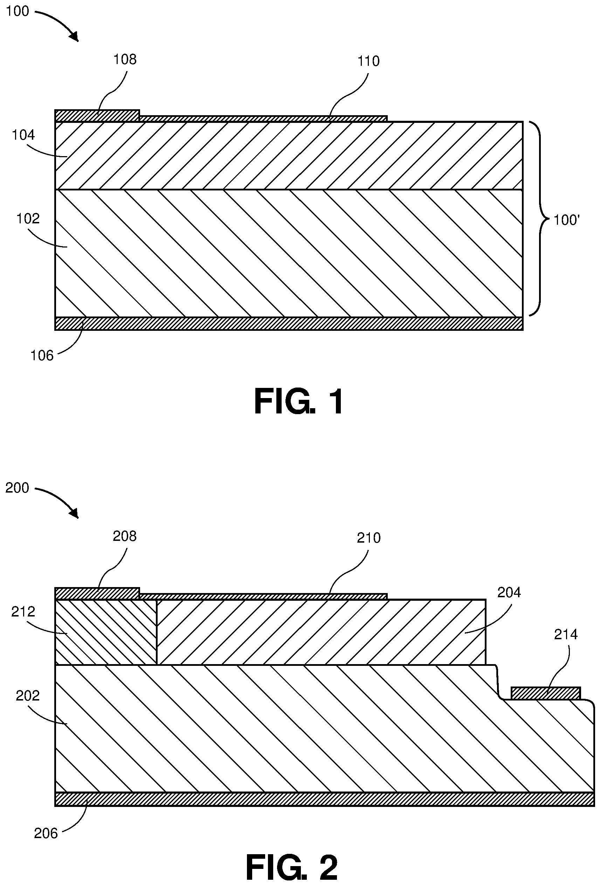

FIG 1 is a cross-sectional views of some aspects of a prior art solar cell structure, in accordance with the present disclosure. Referring to FIG. 1, aspects of a photovoltaic device are illustrated as solar cell structure 100. Solar cell structure 100 includes a tandem solar cell 100'. Solar cell structure 100 may include a first (front or top) contact layer, shown as an n-side metal contact 108, and/or a second (back or bottom) contact layer 106. The metal contact 108 may be positioned over a front surface of the solar cell structure 100 with the second p-side contact layer 106 positioned over a back surface of the solar cells 100'. When a front surface of the solar cell structure 100 is exposed to electro-magnetic radiation, such as solar radiation, the solar cell 100' can produce a voltage across its respective front surface and back surface. In examples, the n-side metal contact 108 can be alternately embodied as a p-side contact and the second contact layer 106 can be an n-side contact in an inverted orientation example. In other examples, one or more layers of an anti-reflective coating layer, not depicted here, can be included in the solar cell structure 100.

The solar cell 100' may include one or more subcells; i.e., solar cell 100' may comprise multijunction solar cells. The subcells may be referred to by the order in which light strikes each subcell as it enters the front surface of the solar cell structure 100. For instance in FIG. 1, a frontside subcell may also be referred to as the top subcell 104, a backside subcell (adjacent to the back surface) may also be referred to as bottom subcell 102. In the case of alternate example solar cell structures, a subcell between top subcell 104 and bottom subcell 102 could be referred to as a middle subcell. In general, a cell structure may have n subcells that may be electrically connected in series, where n may be equal to 1 for a single-junction cell, or n may be any integer greater than or equal to 2 for a multijunction cell. Multiple subcell structures are known to those skilled in the art and not shown herein for purposes of clarity.

One or more tunnel junctions may connect the subcells. For example, in one implementation of a multijunction solar cell, one or more tunnel junctions may be disposed between top subcell 104 and a middle subcell to connect the subcells in electrical series. In an implementation, one or more tunnel junctions may be disposed between the middle subcell and the bottom subcell 102 to connect the subcells in electrical series. In general, each of the n subcells in a multijunction photovoltaic cell, such as solar cell structure 100 FIG. 1, may be connected in series to the adjacent subcell(s) by one or more tunnel junctions in order to form a monolithic, two-terminal, series-interconnected multijunction cell. In a two-terminal configuration it can be desirable to design the subcell thicknesses and bandgaps such that each subcell has nearly the same current at the maximum power point of the current-voltage curve of each subcell, in order that one subcell does not severely limit the current of the other subcells. Alternatively, the subcells may be contacted by means of additional terminals, for instance, metal contacts to laterally conductive semiconductor layers between the subcells, to form 3-terminal, 4-terminal, and in general, m-terminal multijunction cells (m being an integer greater than or equal to 2, and less than or equal to 2n, where n is the number of active subcells in the solar cell structure). The subcells can be interconnected in circuits using these additional terminals such that most of the available photogenerated current density in each subcell can be used effectively. Such effective use may lead to high efficiency for the multijunction cell, even if the photogenerated current densities are very different in the various subcells.

The one or more subcells may comprise the same or different substructures based, in part, on their locations in the solar cell structure 100, for example, depending on their configurations as the top subcell 104, the at least one middle subcell (when present), or the bottom subcell 102.

In one implementation of a solar cell structure 100, for example, comprising a multijunction solar cell structure, solar cell 100' includes a first subcell and a second subcell. The first subcell includes a base semiconductor layer and another semiconductor layer. The base semiconductor layer comprises a p-type semiconductor, such as a p-type group III-V semiconductor material, and the other semiconductor layer may comprise an emitter semiconductor layer which may comprise an n-type semiconductor material. The second subcell includes an absorber layer, wherein the absorber layer comprises an organometallic halide ionic solid perovskite semiconductor material. Generally, the organometallic halide ionic solid perovskite semiconductor material of the absorber layer may be represented by the formula, ABX3, where A comprises an organic ion, B comprises a group-IV ion, and X comprises a halide ion. The organic ion may comprise methylammonium (MA), formamidine (FA), at least one alkali metal, or combinations thereof, wherein the alkali metal may comprise cesium (Cs), rubidium (Rb) or both. The group-IV ion may comprise Pb⁺, Sn⁺, or a combination thereof and the halide ion may comprise Cl⁻, Br, I⁻, or combinations thereof. In an example, the organometallic halide ionic solid perovskite of the absorber layer of the second subcell may comprise methylammonium lead iodide (CH₃NH₃PbI₃), methylammonium lead bromide (CH₃NH₃PbBr₃), methylammonium lead chloride (CH₃NH₃PbCl₃), methylammonium tin bromide (CH₃NH₃SnI₃), methylammonium tin bromide (CH₃NH₃SnBr₃), formamidinium lead iodide (NH₂CH=NH₂PbI₃), or mixtures thereof. Generally, n-type materials need to have a Valence Band Level (Ev) that is lower than the absorber layer comprising the perovskite as this limits the injection of the minority carrier holes into the emitter. Additional applicable low temperature deposition materials can include polymer materials suitable for PV applications.

FIG. 2 is a cross-sectional view of some aspects of a multijunction solar cell structure, in accordance with the present disclosure. FIG. 2 shows a perovskite/silicon 2J example tandem solar cell 200 in cross-section. The multifunction photovoltaic device includes a substrate layer 202 incorporating a silicon n-on-p bottom junction 202 and layered with a perovskite n-on-p top junction layer 204. On an opposite side of the substrate layer 202 is a p-side contact 206, in this example, on the backside. The perovskite n-on-p top junction layer 204 does not completely cover the substrate layer 202 bottom junction, as a portion is covered with a passivation layer 212 to prevent shorting of the perovskite n-side contact to n-side of the silicon bottom junction. This passivation layer 212, or insulating layer has an n-side metal contact pad 208 attached on an exposed surface. In other examples, an inverted orientation can place this on a p-side. Attached to the metal contact 208 is an interconnect tab 210, which in this example, is shown as a metal grid finger or transparent conductor in contact with the contact pad 208 and the perovskite n-on-p top junction layer 204. Additionally, a portion of the substrate layer 202 is etched to add a p-side contact 214 to facilitate connections between multiple solar cells 200.

In examples of the multijunction photovoltaic device of the present disclosure, a first subcell comprises a base semiconductor layer and a second semiconductor layer, wherein the base semiconductor layer comprises a Group III-V semiconductor material. A second subcell comprises an absorber layer, wherein the absorber layer comprises an organometallic halide ionic solid perovskite semiconductor material. In some examples, the absorber layer does not include an organometallic halide ionic solid perovskite semiconductor material. Also present is the insulating passivation layer on at least a portion of a top surface of the first subcell, and an n-side metal pad in contact with the passivation layer on an n-side of the second subcell. Where the interconnection tab comprises a metal, illustrative examples of that metal include low resistance metals such as silver, copper, various alloys, or complex structures such as multilayered structures or alloys, as disclosed herein.

The insulating layer or passivation layer can include an oxide or sulfide layer in examples. Illustrative examples can include, but are not limited to materials such as insulative oxides and sulfides such as SiO₂, Al₂O₃, TiO₂, Ta₂O₅, HfO₂, ZnS, and combinations thereof. In examples, the n-side metal pad and the interconnection tab are on a single side of the multijunction photovoltaic device. For example, the the n-side metal pad and the interconnection tab are both on the n-side of the second subcell, or alternatively on the p-side of the multijunction photovoltaic device. The passivation layer can be deposited or layered adjacent to the second subcell, or in an orientation where the second subcell does not completely cover the first subcell.

In some general implementations of the devices described herein, a solar cell structure comprises a 2-junction solar cell structure such as that in FIG. 1 or FIG. 2. In a first implementation of a 2-junction solar cell structure, the first subcell comprising the III-V semiconductor material in the base semiconductor layer may be configured as a top subcell, such as top subcell. Accordingly, the second subcell comprising the organometallic halide ionic solid perovskite semiconductor material in the absorber layer may be configured as a bottom subcell, such as bottom subcell.

Perovskite materials may be susceptible to UV light. A UV absorbing layer may be placed between the organometallic halide ionic solid perovskite semiconductor material and the source of the electromagnetic energy comprising UV light. This positioning allows from some to all of UV light reaching the device to be absorbed within a subcell comprising a UV-absorbing active layer and minimizes or prevents the UV light to penetrate and/or degrade the perovskite layer. Accordingly, in an expression of the first implementation, the III-V semiconductor may be selected to absorb UV-light and serves as a UV-protectant for the perovskite of the bottom subcell. Thus, a bandgap of the base semiconductor may be larger than the bandgap of the organometallic halide ionic solid perovskite. In a second implementation of a 2-junction solar cell structure, the second subcell comprising the organometallic halide ionic solid perovskite semiconductor material in the absorber layer may be configured as a top subcell such as top subcell 104. In an expression of the second implementation of the 2-junction solar cell, a bandgap of the base semiconductor may be smaller than the bandgap of the organometallic halide ionic solid perovskite.

In some implementations, a solar cell structure comprises a 3-junction solar cell structure. A 3-junction solar cell structure can be similar to solar cell structures from FIG. 1 or FIG. 2 but its solar cell includes an additional third subcell as a middle subcell. In a first implementation of a 3-junction solar cell, the second subcell comprising the organometallic halide ionic solid perovskite semiconductor material in the absorber layer may be configured as a top subcell such as top subcell. The third subcell may be configured as a bottom subcell, such as bottom subcell. Accordingly, the first subcell comprising the III-V semiconductor material in the base semiconductor layer may be configured as a middle subcell, such as middle subcell. In an expression of the first implementation of the 3-junction solar cell, a bandgap of the base semiconductor may be larger than a bandgap of the organometallic halide ionic solid perovskite. In examples of multijunction solar cells or photovoltaic devices, all subcells are in electrical contact with one another.

Additional layers, while not shown in FIG 1 or FIG. 2, may be included without departing from the scope of the present disclosure. For example, a conventional characteristic of PV cells has been the use of a window layer on an emitter layer disposed on the base of the PV cell. The primary function of the window layer is to reduce minority-carrier recombination (i.e., to passivate) the front surface of the emitter. Additionally, the optical properties of the window material must be such that as much light as possible is transmitted to lower cell layers where the photogenerated charge carriers can be collected more efficiently, or if there is substantial light absorption in the window, the minority-carrier lifetime in the window must be sufficiently long for the carriers to be collected efficiently at the p-n junction between the emitter and base of the PV cell. Similarly, a back-surface field (BSF) structure below the PV cell base has been used to reduce minority-carrier recombination at the back surface of the base. As for the window, the BSF structure must have optical properties which allow most of the light that can be used by the subcells beneath the BSF to be transmitted by the BSF, and/or the minority-carrier properties in the BSF must be such that electrons and holes which are generated by light absorption in the BSF are efficiently collected at the p-n junction of the PV cell.

Additionally, in perovskite cells, the use of buffer layer and/or a hole transport material (HTM) layer allow electrons or holes to pass from perovskite absorber layer and block the opposite carrier. This arrangement forces one way (diode) behavior. The n-side buffer layer and the HTM layer in a perovskite subcell may each comprise corresponding bandgap values that are greater than or equal to that of the perovskite layer. If formed adjacent to the perovskite layer, the HTM layer may have valence band energy (Ev) substantially equal to an Ev of the perovskite layer. If formed adjacent to the perovskite layer, the n-side buffer layer interface may have conduction band energy (Ec) substantially equal to an Ec of the perovskite layer.

The bottom subcell may be disposed on a growth substrate. The growth substrate may be electrically, or, it may be electrically active, thereby forming one of the n subcells in a multijunction photovoltaic device. Additional layers such as a support layer, a reflective layer, anti-reflective coating (ARC), and/or a cover glass layer may be additionally included in the solar cell structure 100.

Several variations of photoactive substructures are available for use as subcells in solar cell structures, such as the structures 100 of FIG. 1, or the solar cell 200 structure of FIG. 2. Other components, substructures, or additional layers such as emitter-base subcells, base semiconductor layers, emitter semiconductor layers, window layers; BSF layers, emitter-absorber subcells, absorber layers, HTM layers, absorber-base subcells, absorber layers, buffer layers, emitter-absorber-base subcells, emitter-active substrate subcells, base semiconductor substrates, nucleation layers, and the like, are addressed in U.S. Patent No. 10,861,992, which is hereby incorporated by reference in its entirety herein.

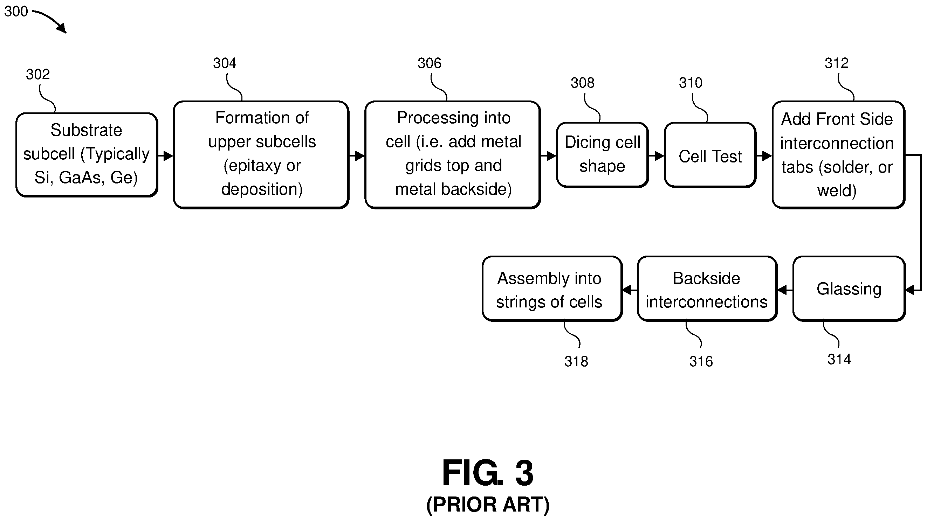

FIG. 3 is a flowchart illustrating a prior art method of fabricating a solar cell, in accordance with the present disclosure. The prior art method for forming a multijunction solar cell 300 begins with forming a substrate subcell 302, which typically comprises silicon, germanium arsenide, or germanium, Mo (molybdenum), InP, SiGe alloy, Si on Si on Glass (SoG) Ge on Insulator (GeoI), or combinations thereof. Next, is a step including forming one or more upper subcells 304 via epitaxy or deposition and processing the subcells into a solar cell 306 by the addition of metal grids on top and metal on backside of the multijunction cell. Materials and configurations of other solar cell device implementations as described herein can be produced by this method. After processing the subcells into a solar cell 306, dicing the cell into shape 308 and testing the cell 310 can be conducted, along with adding a front side interconnection tab 312 by soldering or welding at elevated temperatures. Example temperature ranges for this step include from about 100°C to 500°C, or >150°C to <300°C. Additional steps of glassing 314, adding backside interconnections 316, and assembly of one or more cells into strings of cells 318 can be performed to complete a multijunction photovoltaic device or array thereof.

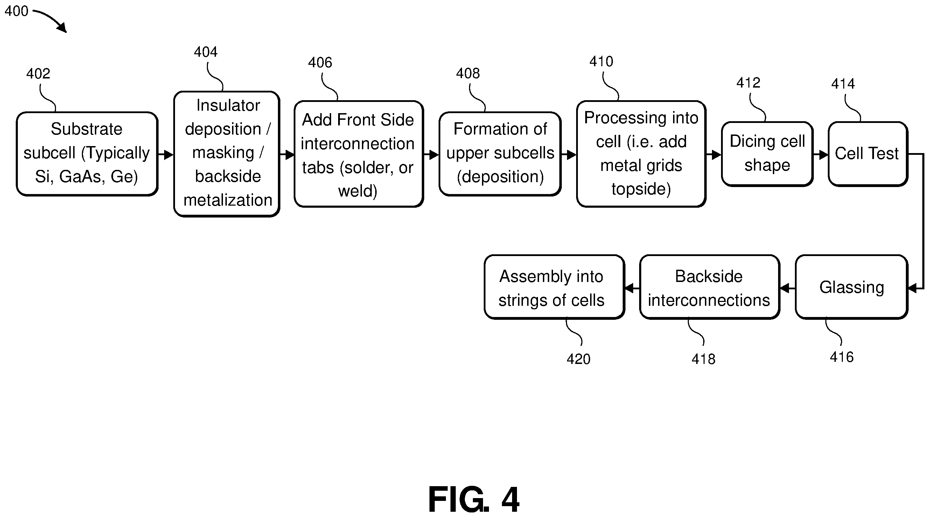

FIG. 4 is a flowchart illustrating a method of fabricating a solar cell, in accordance with the present disclosure. The present disclosure provides a method 400 of fabricating a solar cell, which comprises forming a substrate subcell 402, depositing an insulator 404 including masking, a step which can include backside metallization. This formation of the insulator can protect an n-side of the substrate cell, allowing for a higher temperature metal deposition on the insulator. Further steps include adding a front side interconnection tab 406 by soldering or welding, as before, and forming one or more upper subcells 408 via epitaxy or deposition. It should be noted that upper subcell formation is performed after interconnection attachment. By fabricating a photovoltaic device in such a manner, this separates the high temperature operations such as welding or soldering from the lower temperature sensitive steps involving formation of one or more upper subcells using materials that can degrade or be otherwise compromised upon exposure to higher temperature operations referred to herein. Next are the steps of processing the subcells into a cell 410, which can include front-side metallization connecting to pads using a low temperature deposition and dicing the cell into shape 412. Dicing could alternatively be done prior to upper subcell formation (as shown in step 408). Next, testing the cell 414 can be conducted, followed by the additional steps of glassing 416, adding backside interconnections 418, and assembly of one or more cells into strings of cells 420, such as assembly of one or more multijunction solar cells into an array of cells, which can be performed to complete a multijunction photovoltaic device or array thereof.

In illustrative examples, the method of forming a multijunction solar cell, can include forming a substrate subcell comprising an n-side, a backside, a base semiconductor layer and a second semiconductor layer, wherein the base semiconductor layer comprises a Group III-V semiconductor material, forming passivation layer to protect an n-side of the substrate subcell, forming a high temperature metal deposition on a backside of the substrate subcell, forming a frontside interconnection tab in contact with the passivation layer, forming a second subcell comprising an absorber layer, wherein the absorber layer comprises a perovskite semiconductor material, and forming a front-side metallization connecting to pads using a low temperature deposition. The high temperature metal deposition is conducted at a first temperature, ranging from about 100°C to about 400°C, from about 300°C to about 500°C or from about 300°C to about 800°C. The low, second temperature metallization can be conducted at temperatures that will not degrade or decompose any perovskite or other high temperature sensitive materials. The lower, second temperature deposition can be conducted at temperatures ranging from about 100°C to 500°C, or >150°C to <300°C. The lower, second temperature is conducted at a temperature or temperature range such that a perovskite-based material, or other material susceptible to degradation at higher temperatures not be degraded or destroyed. Implementations include where the passivation layer comprises an oxide layer. The interconnection tab is in contact with the second subcell in a multijunction solar cell when formed by the method of the present disclosure. In examples, the substrate subcell comprises a base semiconductor layer comprising Si, GaAs, or Ge. In certain examples, the order of processing in the present method can be conducted in alternate orders or with additional applicable steps.

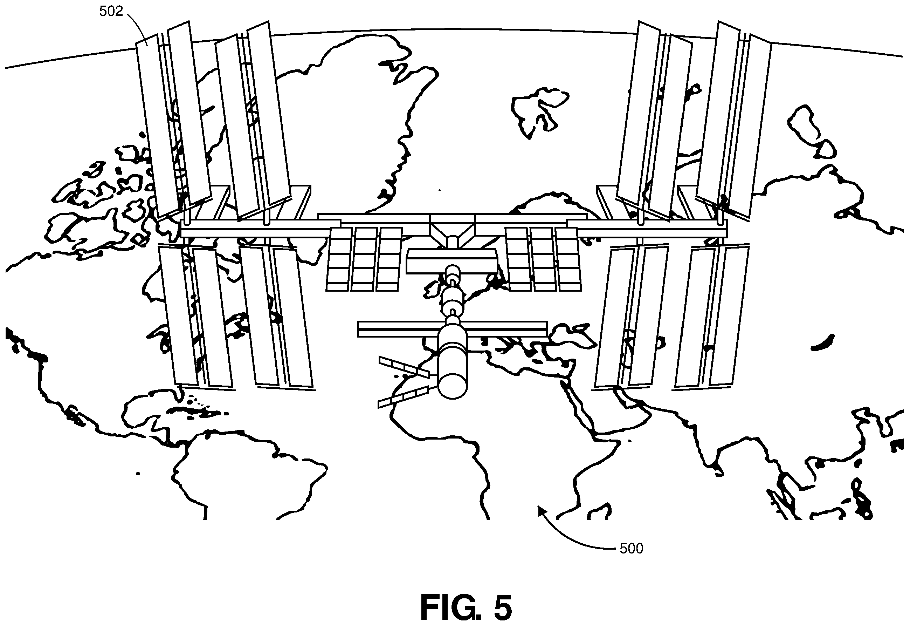

FIG. 5 is a diagram of the International Space Station (ISS) which may employ the disclosed multijunction photovoltaic device(s). In yet a further implementation, an article may comprise a solar cell array. The article may be a vehicle, such as sea, land, air or space vehicle, or may be a satellite system. The solar cell array may be operably coupled to the article. In one such example, the article is a satellite. In one example, the article is the international space station (ISS) 500 as shown in FIG. 5 and a solar cell array 502 is operably coupled to the international space station. The solar cell array 502 may comprise at least one photovoltaic device that includes a Group III-V material layer, and in certain examples, at least one perovskite material layer, wherein the Group III-V material layer may be a layer in a first subcell and the at least one perovskite material layer may be a layer in a second subcell. Alternatively, the Group III-V material layer and the at least one perovskite material layer may be layers in a single subcell of a multijunction photovoltaic device comprising a plurality of subcells. For example, the solar cell array 502 may comprise at least one photovoltaic device as described above in regard to the preceding figures, respectively.

Further, the disclosure comprises embodiments according to the following clauses:
Clause 1. A multijunction photovoltaic device, comprising:
   a first subcell comprising a base semiconductor layer and a second semiconductor layer, wherein the base semiconductor layer comprises a Group III-V semiconductor material;
   a second subcell on the first subcell comprising an absorber layer, wherein the absorber layer comprises an organometallic halide ionic solid perovskite semiconductor material;
   a passivation layer on at least a portion of a top surface of the first subcell; and an n-side metal pad in contact with the passivation layer on an n-side of the second subcell.
Clause 2. The multijunction photovoltaic device of clause 1, further comprising an interconnection tab in contact with the n-side metal pad.
Clause 3. The multijunction photovoltaic device of clause 2, wherein the interconnection tab is in contact with the second subcell.
Clause 4. The multijunction photovoltaic device of clause 2 or 3, wherein the interconnection tab comprises a metal.
Clause 5. The multijunction photovoltaic device of clause 4, wherein the n-side metal pad and the interconnection tab comprise two different metals.
Clause 6. The multijunction photovoltaic device of any of clauses 1 to 5, wherein the passivation layer comprises an oxide layer.
Clause 7. The multijunction photovoltaic device of clause 6, wherein the passivation layer comprises a material selected from a group consisting of SiO₂, Al₂O₃, TiO₂, Ta₂O₅, HfO₂, ZnS, and combinations thereof.
Clause 8. The multijunction photovoltaic device of clause 2, wherein the n-side metal pad and the interconnection tab are on a single side of the multijunction photovoltaic device.
Clause 9. The multijunction photovoltaic device of any of clauses 1 to 8, wherein the passivation layer is adjacent to the second subcell.
Clause 10. The multijunction photovoltaic device of any of clauses 1 to 9, wherein the second subcell does not completely cover the first subcell.
Clause 11. A multijunction photovoltaic device, comprising:
   a first subcell comprising a base semiconductor layer and a second semiconductor layer, wherein the base semiconductor layer comprises a Group III-V semiconductor material;
   a second subcell on the first subcell comprising an absorber layer, wherein the absorber layer does not comprise a perovskite semiconductor material;

   a passivation layer on at least a portion of a top surface of the first subcell;
   an n-side metal pad in contact with the passivation layer on an n-side of the second subcell; and a grid finger in contact with the n-side metal pad and the second subcell.
Clause 12. The multijunction photovoltaic device of clause 11, wherein the passivation layer is adjacent to the second subcell.
Clause 13. The multijunction photovoltaic device of clause 11 or 12, wherein the second subcell does not completely cover the first subcell.
Clause 14. A method of forming a multijunction solar cell, comprising:
   forming a substrate subcell comprising an n-side, a backside, a base semiconductor layer and a second semiconductor layer, wherein the base semiconductor layer comprises a Group III-V semiconductor material;
   forming a passivation layer to protect an n-side of the substrate subcell; forming a metal deposition on a backside of the substrate subcell at a first temperature;
   forming an interconnection tab in contact with the passivation layer;

   forming a second subcell comprising an absorber layer, wherein the absorber layer does not comprise a perovskite semiconductor material; and
   forming a front-side metallization connecting to pads using a deposition of a metal at a second temperature.
Clause 15. The method of forming a multijunction solar cell of clause 14, wherein the passivation layer comprises an oxide layer.
Clause 16. The method of forming a multijunction solar cell of clause 14 or 15, wherein the interconnection tab is in contact with the second subcell.
Clause 17. The method of forming a multijunction solar cell of any of clauses 14 to 16, wherein the substrate subcell comprises base semiconductor layer comprises Si, GaAs, or Ge.
Clause 18. The method of forming a multijunction solar cell of any of clauses 14 to 17, further comprising assembly of one or more multijunction solar cells into an array of cells.
Clause 19. The method of forming a multijunction solar cell of any of clauses 14 to 18, further comprising forming the interconnection tab by soldering at an elevated temperature.
Clause 20. The method of forming a multijunction solar cell of any of clauses 14 to 19, further comprising forming the interconnection tab by welding at an elevated temperature.

While the present teachings have been illustrated with respect to one or more implementations, alterations and/or modifications may be made to the illustrated examples without departing from the spirit and scope of the appended claims. For example, it may be appreciated that while the process is described as a series of acts or events, the present teachings are not limited by the ordering of such acts or events. Some acts may occur in different orders and/or concurrently with other acts or events apart from those described herein. Also, not all process stages may be required to implement a methodology in accordance with one or more aspects or embodiments of the present teachings. It may be appreciated that structural objects and/or processing stages may be added, or existing structural objects and/or processing stages may be removed or modified. Further, one or more of the acts depicted herein may be carried out in one or more separate acts and/or phases. Furthermore, to the extent that the terms "including," "includes," "having," "has," "with," or variants thereof are used in either the detailed description and the claims, such terms are intended to be inclusive in a manner similar to the term "comprising." The term "at least one of" is used to mean one or more of the listed items may be selected. Further, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment. The terms "couple," "coupled," "connect," "connection," "connected," "in connection with," and "connecting" refer to "in direct connection with" or "in connection with via one or more intermediate elements or members." Finally, the terms "exemplary" or "illustrative" indicate the description is used as an example, rather than implying that it is an ideal. Other embodiments of the present teachings may be apparent to those skilled in the art from consideration of the specification and practice of the disclosure herein. It is intended that the specification and examples be considered as exemplary only, with a true scope and spirit of the present teachings being indicated by the following claims.

## Claims

1. A multijunction photovoltaic device, comprising:
a first subcell comprising a base semiconductor layer and a second semiconductor layer, wherein the base semiconductor layer comprises a Group III-V semiconductor material;
a second subcell on the first subcell comprising an absorber layer, wherein the absorber layer comprises an organometallic halide ionic solid perovskite semiconductor material;
a passivation layer (212) on at least a portion of a top surface of the first subcell; and
an n-side metal pad in contact with the passivation layer (212) on an n-side of the second subcell.

2. The multijunction photovoltaic device of claim 1, further comprising an interconnection tab in contact with the n-side metal pad.

3. The multijunction photovoltaic device of claim 2, wherein the interconnection tab is in contact with the second subcell.

4. The multijunction photovoltaic device of claim 2 or 3, wherein the interconnection tab comprises a metal, wherein the n-side metal pad and the interconnection tab preferably comprise two different metals.

5. The multijunction photovoltaic device of claim 2, 3 or 4, wherein the n-side metal pad and the interconnection tab are on a single side of the multijunction photovoltaic device.

6. The multijunction photovoltaic device of any of claims 1 to 5, wherein the passivation layer (212) comprises an oxide layer, wherein the passivation layer (212) preferably comprises a material selected from a group consisting of SiO₂, Al₂O₃, TiO₂, Ta₂O₅, HfO₂, ZnS, and combinations thereof.

7. The multijunction photovoltaic device of any of claims 1 to 6, wherein the passivation layer (212) is adjacent to the second subcell.

8. The multijunction photovoltaic device of any of claims 1 to 7, wherein the second subcell does not completely cover the first subcell.

9. A multijunction photovoltaic device, comprising:
a first subcell comprising a base semiconductor layer and a second semiconductor layer, wherein the base semiconductor layer comprises a Group III-V semiconductor material;
a second subcell on the first subcell comprising an absorber layer, wherein the absorber layer does not comprise a perovskite semiconductor material;
a passivation layer (212) on at least a portion of a top surface of the first subcell;
an n-side metal pad in contact with the passivation layer (212) on an n-side of the second subcell; and
a grid finger in contact with the n-side metal pad and the second subcell.

10. The multijunction photovoltaic device of claim 9, wherein the passivation layer (212) is adjacent to the second subcell.

11. The multijunction photovoltaic device of claim 9 or 10, wherein the second subcell does not completely cover the first subcell.

12. A method of forming a multijunction solar cell (300), comprising:
forming a substrate subcell (302) comprising an n-side, a backside, a base semiconductor layer and a second semiconductor layer, wherein the base semiconductor layer comprises a Group III-V semiconductor material;
forming a passivation layer (212) to protect an n-side of the substrate subcell;
forming a metal deposition on a backside of the substrate subcell at a first temperature;
forming an interconnection tab in contact with the passivation layer (212);
forming a second subcell comprising an absorber layer, wherein the absorber layer does not comprise a perovskite semiconductor material; and
forming a front-side metallization connecting to pads using a deposition of a metal at a second temperature.

13. The method of forming a multijunction solar cell (300) of claim 12, wherein the passivation layer (212) comprises an oxide layer.

14. The method of forming a multijunction solar cell (300) of claim 12 or 13, wherein the interconnection tab is in contact with the second subcell.

15. The method of forming a multijunction solar cell (300) of any of claims 12 to 14, wherein the substrate subcell comprises base semiconductor layer comprises Si, GaAs, or Ge.
